# EUROPÄISCHE PATENTANMELDUNG

(11) **EP 4 683 148 A1**
(43) Veröffentlichungstag der Anmeldung: **21.01.2026**
(21) Anmeldenummer: 25189950.6
(22) Anmeldetag: 16.07.2025
(51) Int. Cl.: H02H 3/02, H02H 3/16, H02H 9/08, G01R 27/18, G01R 31/08

(54) **VERFAHREN UND VORRICHTUNG ZUM NACHWEISEN EINES FEHLERSTROMS EINER ELEKTRISCH VON DER UMGEBUNG ISOLIERT ZU BETREIBENDEN ELEKTRISCHEN ANLAGE**

(30) Priorität: 17.07.2024 DE 102024120238
(71) Anmelder: EFE Elektronik-Forschungs- und Entwicklungsgesellschaft mbH, 64367 Mühltal/Nieder-Ramstadt (DE)
(72) Erfinder: Rychetsky, Willi, 64367 Mühltal (DE); Rychetsky, Matthias, 64367 Mühltal (DE)
(74) Vertreter: Habermann Intellectual Property Partnerschaft von Patentanwälten mbB

(57) **Zusammenfassung**

Bei einem Verfahren zum Feststellen eines zu hohen Fehlerstroms einer elektrisch von der Umgebung isoliert zu betreibenden elektrischen Anlage (2) wird in Abhängigkeit von einem Ausgleichsvorzeichen der in dem Vorzeichenermittlungsschritt erfassten Potentialdifferenz das Umgebungsreferenzpotential über einen Gleichstromausgleichwiderstand (21) für eine vorgebbare Ausgleichszeitdauer entweder mit einem gegenüber einem Anlagenreferenzpotential (15) höheren Hochpotential (9) oder einem niedrigeren Niedrigpotential (10) der elektrischen Anlage (2) elektrisch leitend verbunden. In einem Gleichstromüberprüfungsschritt wird überprüft, ob innerhalb einer vorgebbaren Ausgleichsmessdauer mit gegebenenfalls mehreren Gleichstromausgleichsschritten in dem zuletzt durchgeführten Gleichstromausgleichsschritt mit dem Ausgleichsstrom die mit einer Potentialdifferenzmesseinrichtung (17) erfasste Potentialdifferenz zwischen dem Umgebungsreferenzpotential und dem Anlagenreferenzpotential (15) unter einen vorgebbaren Potentialdifferenzminimalwert reduziert wurde. Anderenfalls wird ein Fehlerstromalarmereignis (32) ausgelöst.

## Beschreibung

Die Erfindung betrifft ein Verfahren zum Feststellen eines zu hohen Fehlerstroms einer elektrisch von der Umgebung isoliert zu betreibenden elektrischen Anlage. Die Erfindung betrifft auch eine Vorrichtung zum Feststellen eines zu hohen Fehlerstroms einer elektrisch von der Umgebung isoliert zu betreibenden elektrischen Anlage, wobei die Vorrichtung eine Erdpotentialkontakteinrichtung aufweist.

Als Fehlerstrom wird ein elektrischer Strom bezeichnet, der aufgrund eines Isolationsfehlers einer elektrisch betriebenen Einrichtung über eine gegebene Fehlerstelle der elektrischen Einrichtung fließt. Dieser Fehlerstrom ist in der Regel ein Strom, der einen ohmschen Ursprung hat und je nach Anwendung und elektrischer Einrichtung unterschiedliche und von der Netzfrequenz, mit welcher die elektrische Einrichtung betrieben wird, abweichende Frequenzen haben kann. In vielen Fällen sollten Fehlerströme bei einer elektrischen Einrichtung rechtzeitig erkannt werden, um zu verhindern, dass es aufgrund von Isolationsfehlern und dadurch ermöglichten Fehlerströmen nicht zu einem Personenschaden oder einem Brand kommen kann.

Bei elektrischen Anlagen, beispielsweise ein in einem Haushalt elektrisch betriebenes Haushaltsgerät, kann als Schutzmaßnahme zur Vermeidung von Fehlerströmen vorgesehen sein, dass die elektrisch betriebene Anlage dauerhaft elektrisch leitend mit einem Erdpotential verbunden ist und eine Potentialdifferenz, die ungewollt zwischen einer Komponente der elektrischen Anlage und der davon isolierten Umgebung auftreten könnte, über die elektrisch leitende Verbindung mit dem Erdpotential ausgeglichen wird. Zu diesem Zweck ist üblicherweise ein gesonderter Schutzleiter bei der elektrischen Stromversorgung der elektrischen Anlage vorgesehen, über den ein eventuell auftretender Fehlerstrom zusammen mit weiteren Ableitströmen abgeleitet wird, wobei der Schutzleiter mit dem Erdpotential verbunden ist.

Aus der Praxis sind verschiedene Anwendungsfälle bekannt, bei denen ein eventuell auftretender großer Fehlerstrom nicht erwünscht oder nicht zulässig ist, auch wenn er über eine elektrisch leitende Verbindung mit dem Erdpotential abgeleitet werden könnte. So unterliegen beispielsweise Patientenrufanlagen nach DIN VDE 0834-1 für die elektrische Sicherheit der Norm DIN EN 60601-1 hinsichtlich der Spannungsfestigkeit gegenüber anderen Anlagen und der maximal zulässigen Ableitströme zu einem Erdpotential. Solche Patientenrufanlagen, welche die Anforderungen einer besonders strengen Schutzklasse erfüllen sollen, dürfen beispielsweise keine Verbindung zu einem Erdpotential haben, über die ein Fehlerstrom fließen kann, der größer als ein vorgegebener Grenzwert ist. Der Grenzwert ist dabei üblicherweise so vorgegeben, dass der Fehlerstrom, der über einen einem menschlichen Körper entsprechenden Widerstand fließen würde, ausreichend gering ist, um eine Beeinträchtigung einer Person zu vermeiden, die ungewollt so mit der elektrischen Anlage in Kontakt kommt, dass der Fehlerstrom auch über die Person abfließen könnte.

Aus der Praxis sind verschiedene Verfahren und Vorrichtungen bekannt, mit denen überprüft werden kann, dass eine elektrische Anlage zuverlässig elektrisch isoliert ist und dass während des Betriebs keine unerwünscht hohen Fehlerströme auftreten. Die Messung der über die elektrisch leitende Verbindung zu einem Erdpotential abfließenden Ableitströme kann so erfolgen, dass mittels einer Messbrücke das Erdpotential symmetrisch zu einer positivsten und negativsten Spannung der elektrischen Anlage gehalten und über die Abweichung hiervon der Fehlerstrom gemessen wird. Durch die Abweichung wird ein messbarer Ableitstrom erzeugt, der zwischen der elektrischen Anlage und dem Erdpotential fließt. Wenn der messbare Ableitstrom größer als ein vorgegebener Schwellenwert ist, kann ein Fehlerstromalarmereignis ausgelöst werden. Eine derartige Messung widerspricht aber einer für einige elektrischen Anlagen und insbesondere für Patientenrufanlagen geltenden Anforderung, dass auch während einer Messung keine Ableitströme auftreten sollten, die größer als der vorgegebene Grenzwert sind, der gleichzeitig auch als Schwellenwert für die Auslösung des Fehlerstromalarmereignisses verwendet wird.

Es wird deshalb als eine Aufgabe der vorliegenden Erfindung angesehen, ein Verfahren zum Feststellen eines zu hohen Fehlerstroms einer elektrisch von der Umgebung isoliert zu betreibenden elektrischen Anlage so auszugestalten, dass auch während der Durchführung des Verfahrens kein Ableitstrom zwischen der elektrischen Anlage und einem Erdpotential fließt, der größer als ein vorgegebener Grenzwert ist, der auch als Schwellenwert für die Auslösung eines Fehlerstromalarmereignisses verwendet wird.

Diese Aufgabe wird durch ein Verfahren gelöst, wobei in einem Vorzeichenermittlungsschritt eine elektrische Potentialdifferenz zwischen einem Umgebungsreferenzpotential und einem Anlagenreferenzpotential der elektrischen Anlage erfasst wird, wobei das Anlagenreferenzpotential einem Mittelwert zwischen einem höheren Hochpotential und einem relativ dazu niedrigeren Niedrigpotential der elektrischen Anlage entspricht, wobei in einem gegebenenfalls mehrfach hintereinander durchgeführten Gleichstromausgleichsschritt in Abhängigkeit von einem Ausgleichsvorzeichen der in dem Vorzeichenermittlungsschritt erfassten Potentialdifferenz das Umgebungsreferenzpotential über einen Gleichstromausgleichwiderstand für eine vorgebbare Ausgleichszeitdauer entweder mit dem gegenüber dem Anlagenreferenzpotential höheren Hochpotential oder dem niedrigeren Niedrigpotential der elektrischen Anlage elektrisch leitend verbunden wird, um durch einen durch den Gleichstromausgleichwiderstand fließenden Ausgleichsstrom die Potentialdifferenz zwischen dem Umgebungsreferenzpotential und dem Anlagenreferenzpotential der elektrischen Anlage zu reduzieren, wobei die vorgegebene Ausgleichszeitdauer kürzer als eine Grenzzeitdauer ist, bei welcher eine durch den Gleichstromausgleichwiderstand fließende Ladungsmenge einem vorgebbaren kontinuierlich fließenden Ausgleichsmaximalstrom entspricht, dass in einem Gleichstromüberprüfungsschritt überprüft wird, ob innerhalb einer vorgebbaren Ausgleichsmessdauer mit gegebenenfalls mehreren Gleichstromausgleichsschritten in dem zuletzt durchgeführten Gleichstromausgleichsschritt mit dem Ausgleichsstrom die mit einer Potentialdifferenzmesseinrichtung erfasste Potentialdifferenz zwischen dem Umgebungsreferenzpotential und dem Anlagenreferenzpotential unter einen vorgebbaren Potentialdifferenzminimalwert reduziert wurde, oder ob die Potentialdifferenz zwischen dem Umgebungsreferenzpotential und dem Anlagenreferenzpotential mit dem Ausgleichsstrom nicht unter einen vorgebbaren Potentialdifferenzminimalwert gesenkt werden konnte, und dass in einem Gleichstromauswertschritt ausgehend von einem Ergebnis des Gleichstromüberprüfungsschritts ein Fehlerstromalarmereignis ausgelöst wird, wenn in dem zuletzt durchgeführten Gleichstromausgleichsschritt mit dem Ausgleichsstrom die Potentialdifferenz zwischen dem Umgebungsreferenzpotential und dem Anlagenreferenzpotential nicht unter einen vorgebbaren Potentialdifferenzminimalwert gesenkt werden konnte.

Es wird als ein wesentlicher Aspekt der Erfindung angesehen, dass für die Überprüfung des Fehlerstroms nicht wie üblich kurzzeitig eine elektrisch leitende Verbindung zwischen der elektrischen Anlage und dem Umgebungsreferenzpotential, üblicherweise ein Erdleiter, hergestellt wird und ein Fehlerstromalarmereignis ausgelöst wird, wenn während der Dauer der elektrisch leitenden Verbindung ein zu großer Fehlerstrom zwischen der elektrischen Anlage und dem Umgebungsreferenzpotential fließt, sondern dass über eine vorgebbare Ausgleichsmessdauer mit gegebenenfalls mehreren Gleichstromausgleichsschritten versucht wird, eine eventuell bestehende Potentialdifferenz zwischen dem Anlagenreferenzpotential der elektrischen Anlage und dem Umgebungsreferenzpotential auszugleichen und dadurch unter einen vorgebbaren Schwellenwert für die Potentialdifferenz zu reduzieren, wobei während der einzelnen Gleichstromausgleichsschritte jeweils der durch den Gleichstromausgleichwiderstand fließende Ausgleichsstrom begrenzt und ausreichend gering ist, um den maximal zulässigen Fehlerstrom zwischen der elektrischen Anlage und dem Umgebungsreferenzpotential auch während der Durchführung der Messung nicht zu überschreiten.

Der Ausgleichsstrom kann in einfacher Weise dadurch begrenzt werden, dass die elektrisch leitende Verbindung zwischen dem Anlagenreferenzpotential und dem Umgebungsreferenzpotential, beispielsweise einem Erdleiter, nur für eine derart kurze Zeitdauer bzw. maximal für eine Grenzzeitdauer hergestellt bzw. aufrechterhalten wird, dass die durch den Gleichstromausgleichwiderstand fließende Ladungsmenge einem vorgebbaren kontinuierlich fließenden Ausgleichsmaximalstrom entspricht, der ausreichend gering ist, sodass eventuell relevante gesetzliche oder von einem Anlagenbetreiber vorgegebene Schutzvorschriften, Normen oder im Einzelfall vorgegebene Schutzmaßnahmen erfüllt werden. So kann beispielsweise bei einer maximalen Potentialdifferenz zwischen dem Anlagenreferenzpotential und dem Umgebungsreferenzpotential von 24 Volt und einem Gleichstromausgleichwiderstand von 120 kOhm maximal ein Ausgleichsstrom von 200 µA fließen. Um den maximal fließenden Ausgleichsstrom auf einen Wert zu begrenzen, der einem auf 10 µA vorgegebenen kontinuierlich fließenden Ausgleichsmaximalstrom entspricht, kann die elektrisch leitende Verbindung zwischen dem Anlagenreferenzpotential und dem Umgebungsreferenzpotential über die Ausgleichsmessdauer gegebenenfalls in mehreren Intervallen für eine maximale Gesamtdauer von bis zu 5 % der Ausgleichsmessdauer hergestellt werden, sodass der beispielsweise über eine Gesamtdauer von 0,05 Sekunden mit 200 µA fließende Ausgleichsstrom einem kontinuierlichen Stromfluss von maximal 10 µA entspricht.

Es wird demzufolge anstelle eines gegebenenfalls großen und den maximal zulässigen Fehlerstrom übersteigenden Ableitstroms eine Zeitdauer erfasst, die für den Ausgleich einer eventuell vorliegenden und gegebenenfalls großen Potentialdifferenz zwischen dem Anlagenreferenzpotential der elektrischen Anlage und dem Umgebungsreferenzpotential benötigt wird. Während der Ausgleich durchgeführt wird bzw. während die für den Ausgleich benötigten Gleichstromausgleichsschritte durchgeführt werden, ist der maximal zulässige Ausgleichsstrom, mit welchem die Potentialdifferenz zwischen dem Umgebungsreferenzpotential und dem Anlagenreferenzpotential reduziert wird, zweckmäßigerweise deutlich geringer als ein Grenzwert ist, der auch als Schwellenwert für die Auslösung eines Fehlerstromalarmereignisses vorgegeben ist. Da eine Potentialdifferenz nicht mit einem gegebenenfalls zu hohen Ableitstrom vollständig ausgeglichen wird, sondern lediglich überprüft wird, ob mit dem tatsächlich fließenden Ausgleichsstrom eine eventuell bestehende Potentialdifferenz innerhalb der vorgegebenen Ausgleichsmessdauer ausreichend reduziert werden kann oder aber zu groß für einen Ausgleich ist und der maximal zulässige Ausgleichsstrom ausreichend niedrig vorgegeben werden kann, kann zuverlässig ausgeschlossen werden, dass während der Messung kein Ableitstrom zwischen der elektrischen Anlage und dem Umgebungsreferenzpotential fließt, welcher den maximal zulässigen Fehlerstrom übersteigt.

Wenn über die vorgegebene Ausgleichsmessdauer mit gegebenenfalls mehreren Gleichstromausgleichsschritten eine Potentialdifferenz zwischen dem Anlagenreferenzpotential der elektrischen Anlage und dem Umgebungsreferenzpotential ausgeglichen bzw. unter einen vorgegebenen Schwellenwert reduziert wird, wird davon ausgegangen, dass bei einem unerwünschten elektrisch leitenden Kontakt mit Komponenten der elektrischen Anlage kein Fehlerstrom erzeugt werden und auftreten kann, der über dem maximal zulässigen Fehlerstrom liegt. Falls die Potentialdifferenz zwischen dem Anlagenreferenzpotential der elektrischen Anlage und dem Umgebungsreferenzpotential jedoch innerhalb der Ausgleichsmessdauer nicht ausgeglichen werden kann, wird davon ausgegangen, dass bei einem unerwünschten elektrisch leitenden Kontakt beispielsweise über eine beschädigte Isolierung ein zu großer Fehlerstrom auftreten könnte und deshalb das Fehlerstromalarmereignis ausgelöst werden muss.

Die Ausgleichsmessdauer kann ausreichend kurz vorgegeben werden, um den für die betreffende elektrische Anlage vorgegebenen Sicherheitsanforderungen zu entsprechen. So ist beispielsweise bei Patientenrufanlagen vorgesehen, dass ein zu großer Fehlerstrom spätestens nach 30 Sekunden erfasst werden muss und ein Fehlerstromalarmereignis auslösen muss. Die Ausgleichsmessdauer kann in diesem Fall beispielsweise 10 Sekunden oder 20 Sekunden betragen. Die Ausgleichsmessdauer kann auch in Abhängigkeit von einem vorgegebenen maximal zulässigen Ausgleichsstrom und einer maximal erwarteten Potentialdifferenz wesentlich geringer sein.

Die in einem Gleichstromüberprüfungsschritt durchgeführte Überprüfung, ob innerhalb einer vorgebbaren Ausgleichsmessdauer mit gegebenenfalls mehreren Gleichstromausgleichsschritten in dem zuletzt durchgeführten Gleichstromausgleichsschritt mit dem Ausgleichsstrom die Potentialdifferenz zwischen dem Umgebungsreferenzpotential, beispielsweise einem Erdleiter, und dem Anlagenreferenzpotential unter einen vorgebbaren Potentialdifferenzminimalwert reduziert wurde, kann beispielsweise durch eine Messung der verbleibenden Potentialdifferenz erfolgen, die entweder mit einer elektrisch leitenden Kontaktierung mit einer geeigneten Strom- oder Spannungsmesseinrichtung oder aber kontaktlos durch eine kapazitive Messung durchgeführt werden kann. Es ist ebenfalls möglich, den zeitlichen Verlauf einer Stromstärke des Ausgleichsstroms zu erfassen, der während der Ausgleichsmessdauer zwischen dem Anlagenreferenzpotential der elektrischen Anlage und dem Umgebungsreferenzpotential fließt, und ausgehend davon abzuschätzen, ob der Ausgleichsstrom unterhalb einer Messempfindlichkeitsschwelle oder zumindest am Ende der Ausgleichsmessdauer ausreichend gering ist, sodass eine gegebenenfalls verbleibende Potentialdifferenz unterhalb des vorgegebenen Potentialdifferenzminimalwerts liegt.

In der Praxis kann es zweckmäßig sein, die relevanten Parameter für die Durchführung der Gleichstromausgleichschritte wie beispielsweise die Ausgleichszeitdauer eines Gleichstromausgleichsschritts oder die Anzahl der durchzuführenden Gleichstromausgleichsschritte mit Hilfe einer geeigneten PID-Regelung so vorzugeben, dass unerwünschte Oszillationsbewegungen der Potentialdifferenz oder ein unerwünschtes Aufschaukeln der Potentialdifferenz während der Durchführung des Verfahrens vermieden werden kann.

Falls ein Fehlerstromalarmereignis ausgelöst werden muss kann im einfachsten Fall nur die nicht mehr durch Gleichstromausgleichsschritte mögliche Reduktion einer Potentialdifferenz bzw. die Auslösung des Fehlerstromalarmereignisses angezeigt oder mitgeteilt werden. Es ist jedoch ebenfalls möglich und für eine detailliertere Auswertung des Fehlers bzw. für eine möglichst rasche Behebung des Fehlers vorteilhaft, wenn zusätzlich zu der Auslösung des Fehlerstromalarmereignisses auch ergänzende Informationen wie beispielsweise die Stromstärke des während eines Gleichstromausgleichsschritts erfassten Ausgleichsstroms oder die verwendete Ausgleichsmessdauer oder der verbleibende Potentialdifferenzwert erfasst und für eine Auswertung zur Verfügung gestellt werden. Mit einer geeigneten Auswertung solcher ergänzender Informationen kann gegebenenfalls auch eine qualitative Aussage über die Art des Fehlers oder die möglichen Auswirkungen des Fehlers getroffen werden. So kann beispielsweise durch eine Auswertung von in geeigneter Weise vorgegebenen und ermittelten oder erfassten ergänzenden Informationen auch überwacht und gegebenenfalls festgestellt werden, dass die eigentlich elektrisch isoliert zu betreibende elektrische Anlage unbeabsichtigt eine elektrisch leitende Verbindung zu einem Spannungsleiter eines Haushaltsversorgungsstromkreises aufweist, der gegenüber einem Erdleiter eine Potentialdifferenz von 230 V aufweist, sodass eine Potentialdifferenz zwischen dem Anlagenreferenzpotential und dem Umgebungsreferenzpotential mit den Gleichstromausgleichsschritten keinesfalls reduziert oder zum Ausgleich gebracht werden könnte.

Gemäß einer Ausgestaltung des Erfindungsgedankens ist optional vorgesehen, dass das Hochpotential der elektrischen Anlage dem höchsten elektrischen Potential innerhalb der elektrischen Anlage entspricht, und dass das Niedrigpotential der elektrischen Anlage dem niedrigsten elektrischen Potential innerhalb der elektrischen Anlage entspricht. Auf diese Weise wird durch das geeignet vorgegebene Anlagenreferenzpotential die maximale Potentialdifferenz erfasst, die innerhalb der elektrischen Anlage besteht und einen Fehlerstrom erzeugen könnte. Für viele Anwendungsfälle ist es vorteilhaft, wenn das Anlagenreferenzpotential einem Potentialmittelwert zwischen dem höchsten elektrischen Potential und dem niedrigsten elektrischen Potential innerhalb der elektrischen Anlage entspricht. Das Anlagenreferenzpotential kann beispielsweise durch einen Spannungsteiler, der durch zwei zwischen dem höchsten und niedrigsten elektrischen Potential in Reihe geschaltete Spannungsteilerwiderstände gebildet wird, vorgegeben werden. Bei einer Verwendung von zwei gleich großen Spannungsteilerwiderständen für den Spannungsteiler entspricht ein Potential zwischen den beiden Spannungsteilerwiderständen einem Potentialmittelwert zwischen dem höchsten und dem niedrigsten Potential der elektrischen Anlage.

Bei dem Umgebungsreferenzpotential kann es sich um das elektrische Potential eines Erdleiters eines Haushaltsversorgungsstromkreises handeln. In Abhängigkeit von dem Betrieb der zu überwachenden elektrischen Anlage oder den Zielen der Überwachung kann es zweckmäßig sein, dass als Umgebungsreferenzpotential nicht ein Erdpotential vorgegeben wird, sondern ein geeignetes elektrisches Potential, welches gegenüber dem Anlagenreferenzpotential keinen nennenswerten Unterschied aufweisen soll, was gegebenenfalls auch das Potential eines mit einer Netzspannung beaufschlagten Spannungsleiters eines Haushaltsversorgungsstromkreises oder einer elektrischen Energieversorgung eines Gebäudes sein kann.

Gemäß einer vorteilhaften Ausgestaltung des Erfindungsgedankens ist vorgesehen, dass in dem Gleichstromausgleichsschritt die Ausgleichszeitdauer als Summe von mehreren aufeinanderfolgenden Ausgleichszeitintervallen vorgegeben wird, während der das Umgebungsreferenzpotential über den Gleichstromausgleichwiderstand entweder mit dem gegenüber dem Referenzpotential höheren Hochpotential oder dem niedrigeren Niedrigpotential der elektrischen Anlage elektrisch leitend verbunden ist. Die einzelnen Ausgleichszeitintervalle können so vorgegeben werden, dass die während der Ausgleichszeitdauer insgesamt anfallende Gesamtzeitdauer der betreffenden Ausgleichszeitintervalle ausreichend gering ist, sodass mit der im Einzelfall verwendeten Messvorrichtung kein Ausgleichsstrom erzeugt wird, der einem vorgegebenen kontinuierlich fließenden Ausgleichsmaximalstrom entspricht oder diesen übersteigt. Ein einzelnes Ausgleichszeitintervall kann beispielsweise den maximalen Bruchteil des Ausgleichszeitdauer andauern, der für den Ausgleichsmaximalstrom zulässig ist. Es ist ebenfalls denkbar, dass mehrere Ausgleichszeitintervalle innerhalb der Ausgleichszeitdauer vorgegeben werden, wobei die Gesamtdauer der mehreren Ausgleichszeitintervalle ausreichend gering ist, sodass der dadurch ermöglichte Ausgleichsstrom maximal einem vorgegebenen kontinuierlich fließenden Ausgleichsmaximalstrom entspricht oder geringer als dieser ist.

Es ist optional vorgesehen, dass in einem Langzeitausgleichsschritt nacheinander mehrere Gleichstromausgleichsschritte durchgeführt werden, dass für jeden Gleichstromausgleichsschritt ein Gleichstromüberprüfungsschritt durchgeführt wird und dass der Gleichstromauswerteschritt ausgehend von dem Ergebnis des Gleichstromüberprüfungsschritts des zuletzt in dem Langzeitausgleichsschritt durchgeführten Gleichstromausgleichsschritt durchgeführt wird. Es ist nicht erforderlich, dass nach jedem Gleichstromausgleichsschritt und damit beispielsweise in jeder Millisekunde ein Gleichstromauswerteschritt durchgeführt und gegebenenfalls ein Fehlerstromalarmereignis ausgelöst wird. Es kann auch eine deutlich längere Überwachungsdauer und damit ein Langzeitausgleichsschritt vorgegeben werden, der mehrere Sekunden oder noch deutlich länger dauern kann. Mit einer geeigneten Vorgabe eines Langzeitausgleichschritts kann erreicht werden, dass gegebenenfalls einzuhaltende Sicherheitsstandards und Prüfungskriterien für einen eventuell auftretenden Fehlerstrom eingehalten werden, der für die Durchführung des Verfahrens anfallende Aufwand jedoch so gering wie möglich gehalten wird. Insbesondere kann in einigen Fällen verhindert werden, dass bei einer unnötig kurz vorgegebenen Ausgleichsmessdauer zu rasch ein Fehlerstromalarmereignis ausgelöst wird, da die Potentialdifferenz zwischen dem Referenzpotential der elektrischen Anlage und dem Erdpotential nicht innerhalb der kurz vorgegebenen Ausgleichsmessdauer ausreichend ausgeglichen werden kann. Innerhalb einer geeignet vorgegebenen Langzeitmessdauer, die sich über mehrere Gleichstromausgleichschritte hinweg erstreckt, könnte der Ausgleich jedoch möglich sein, sodass kein Fehlerstromalarmereignis ausgelöst werden muss.

Einer besonders vorteilhaften Ausgestaltung des Erfindungsgedankens zufolge ist vorgesehen, dass während des Langzeitausgleichsschritts für einen ersten oder vorausgehenden Gleichstromausgleichsschritt eine erste Ausgleichszeitdauer vorgegeben wird, und dass für einen nachfolgenden Gleichstromausgleichsschritt eine zweite Ausgleichszeitdauer vorgegeben wird, die länger als die erste Ausgleichszeitdauer ist, wenn in dem Gleichstromüberprüfungsschritt festgestellt wurde, dass innerhalb des ersten oder vorausgehenden Gleichstromausgleichsschritts mit dem Ausgleichsstrom die Potentialdifferenz zwischen dem Umgebungsreferenzpotential und dem Anlagenreferenzpotential nicht unter den vorgegebenen Potentialdifferenzminimalwert reduziert wurde, und dass die zweite Ausgleichszeitdauer kürzer oder gleich der ersten Ausgleichsdauer ist, wenn in dem Gleichstromüberprüfungsschritt festgestellt wurde, dass innerhalb des ersten oder vorausgehenden Gleichstromausgleichsschritts die Potentialdifferenz zwischen dem Umgebungsreferenzpotential und dem Anlagenreferenzpotential mit dem Ausgleichsstrom unter den vorgegebenen Potentialdifferenzminimalwert gesenkt werden konnte. Auf diese Weise kann innerhalb eines Langzeitausgleichsschritts die Ausgleichsdauer innerhalb der aufeinanderfolgenden Gleichstromausgleichsschritte an den voraussichtlich noch erforderlichen Potentialausgleich angepasst werden.

Es ist ebenfalls möglich, dass das erfindungsgemäße Verfahren in zeitlichen Abständen oder kontinuierlich über einen großen Zeitraum hinweg durchgeführt wird. In diesem Fall können eine vorgegebene Anzahl von Langzeitausgleichsschritten durchgeführt werden oder ein vorgegebener Langzeitausgleichsschritt immer wieder wiederholt durchgeführt werden, um den großen Zeitraum abzudecken. Dabei kann ständig eine gegebenenfalls auftretende Potentialdifferenz ausgeglichen werden. Solange der hierfür erforderliche Ausgleichsstrom ausreichend gering bleibt bzw. die Ausgleichszeitdauer oder die einzelnen Ausgleichszeitintervalle hinreichend kurz bleiben, kann keine übermäßig große Potentialdifferenz zwischen der elektrischen Anlage und dem Umgebungsreferenzpotential entstehen, sodass auch kein Fehlerstromalarmereignis ausgelöst werden muss.

Einige elektrische Anlagen, insbesondere sich weiträumig und gegebenenfalls über viele Räume eines Gebäudes hinweg erstreckende elektrische Anlagen wie beispielsweise Patientenrufanlagen können nicht nur durch eine sich mit der Zeit aufbauende Potentialdifferenz zwischen einem Referenzpotential der elektrischen Anlage und einem Erdpotential gestört und deren Betriebssicherheit beeinträchtigt werden, sondern auch beispielsweise durch elektromagnetische Wechselfelder, die gegebenenfalls räumlich begrenzt auf die elektrische Anlage einwirken und eine Wechselspannung zwischen einzelnen Komponenten der elektrischen Anlage erzeugen. Durch eine Wechselspannung, durch welche gegebenenfalls auch zeitlich ansteigende Ladungsspitzen innerhalb der elektrischen Anlage erzeugt werden, können nicht nur einzelne Komponenten der elektrischen Anlage beeinträchtigt oder beschädigt werden, sondern auch deren Betriebssicherheit und die Sicherheit von Personen beeinträchtigt werden, die mit der elektrischen Anlage in Kontakt kommen.

Es ist deshalb gemäß einer vorteilhaften Ausgestaltung des Erfindungsgedankens vorgesehen, dass das Anlagenreferenzpotential über einen Wechselspannungsmesskondensator mit einem Umgebungsreferenzpotential verbunden ist, dass in einem Wechselspannungsprüfschritt überprüft wird, ob eine zwischen dem Anlagenreferenzpotential und dem Hochpotential oder zwischen dem Anlagenreferenzpotential und dem Niedrigpotential innerhalb der elektrischen Anlage erfasste Wechselspannungspotentialdifferenz größer als ein vorgebbarer Wechselspannungswarnschwellenwert ist, dass ein Fehlerstromalarmereignis ausgelöst wird, wenn die erfasste Wechselspannungspotentialdifferenz größer als der Wechselspannungswarnschwellenwert ist, und dass anderenfalls in einem nachfolgenden Wechselstromerfassungsschritt während einer Wechselstrommesszeitdauer der Wechselspannungsmesskondensator elektrisch leitend überbrückt wird und eine mit einer Stromstärke korrelierende Wechselstromkenngröße eines Wechselspannungsableitstromflusses erfasst wird, der durch einen Wechselspannungsmesswiderstand und den überbrückten Wechselspannungsmesskondensator zwischen der elektrischen Anlage und dem Umgebungsreferenzpotential fließt, und dass in einem Wechselstromauswerteschritt ausgehend von der mit dem Wechselstromerfassungsschritt erfassten Wechselstromkenngröße ein Fehlerstromalarmereignis ausgelöst wird, wenn die Wechselstromkenngröße größer als ein vorgegebener Wechselstromschwellenwert ist. Dabei wird zunächst überprüft, ob durch eine auf die elektrische Anlage übertragene Wechselspannung eine Potentialdifferenz erzeugt wird, deren Ausgleich einen übermäßig hohen Ableitstrom bewirken würde, und in diesem Fall gleich ein Fehlerstromalarmereignis ausgelöst. Falls ein gefahrloser Ausgleich dieser Potentialdifferenz möglich erscheint wird in einem Wechselstromerfassungsschritt über eine Wechselstrommesszeitdauer ein Wechselspannungsableitstromfluss zwischen der elektrischen Anlage und dem Umgebungsreferenzpotential zugelassen und mit einer geeigneten Messeinrichtung erfasst. Falls dabei eine mit der Stromstärke des Wechselspannungsableitstromflusses korrelierende Wechselstromkenngröße einen vorgebbaren Wechselstromschwellenwert übersteigt, wird ebenfalls ein Fehlerstromalarmereignis ausgelöst. Nur für den Fall, dass über die Wechselstrommesszeitdauer kein zu hoher Wechselspannungsableitstromfluss auftritt, wird kein Fehlerstromalarmereignis ausgelöst.

Optional ist vorgesehen, dass die Wechselstrommesszeitdauer nicht mit der Ausgleichsmessdauer oder gegebenenfalls nicht mit einem Ausgleichszeitintervall überlappt, sodass während der Wechselstrommesszeitdauer das Umgebungsreferenzpotential nicht gleichzeitig über den Gleichstromausgleichwiderstand entweder mit dem gegenüber dem Referenzpotential höheren Hochpotential oder dem niedrigeren Niedrigpotential der elektrischen Anlage elektrisch leitend verbunden ist. Auf diese Weise kann vermieden werden, dass gleichzeitig überprüft wird, ob eine zu große Potentialdifferenz zwischen dem Umgebungsreferenzpotential und dem Anlagenreferenzpotential oder ein relevanter Wechselspannungsableitstromfluss zwischen der elektrischen Anlage und dem Umgebungsreferenzpotential fließt, und sich dadurch die beiden Messungen beeinflussen oder derart beeinträchtigen könnten, dass es zu fehlerhaften Ergebnissen bzw. zu einer ungerechtfertigten Auslösung des Fehlerstromalarmereignisses oder aber zu einer in unzutreffender Weise unterbleibenden Auslösung des Fehlerstromalarmereignisses kommen könnte. Es kann vorgesehen sein, dass entweder nur ein Gleichstromausgleichsschritt oder ein Langzeitausgleichsschritt mit mehreren Gleichstromausgleichsschritten ausgeführt wird, oder zeitlich beabstandet davon nur ein Wechselstromerfassungsschritt durchgeführt wird. Es kann weiterhin vorgesehen sein, dass immer abwechselnd oder in einer vorgegebenen zeitlichen Abfolge nacheinander ein oder mehrere Gleichstromausgleichsschritte und anschließend ein oder mehrere Wechselstromerfassungsschritte durchgeführt werden. Auf diese Weise kann über einen langen Zeitraum eine dauerhafte Überwachung der elektrischen Anlage erfolgen. Gegebenenfalls kann die Wechselstrommesszeitdauer so angepasst oder durch eine Unterteilung in geeignete Intervalle so vorgegeben werden, dass ein Wechselstromerfassungsschritt oder einzelne Intervalle des Wechselstromerfassungsschritts zwischen aufeinanderfolgenden Ausgleichszeitintervallen eines Gleichstromausgleichsschritts durchgeführt werden, sodass eine parallele Durchführung der beiden Messungen erfolgt.

In vorteilhafter Weise kann vorgesehen sein, dass für den Gleichstromausgleichsschritt und für einen Wechselstromerfassungsschritt sowie für den Gleichstromüberprüfungsschritt, für den Wechselspannungsüberprüfungsschritt und für den Wechselspannungsauswerteschritt unterschiedliche und an die jeweiligen gesetzlichen, normierten oder individuellen Vorgaben angepasste Parameter und Schwellenwerte für die Durchführung vorgegeben werden. Wenn ein Fehlerstromalarmereignis ausgelöst wird, kann nicht nur das Vorliegen eines Fehlerstromalarmereignisses angezeigt oder als Fehlerinformation erzeugt und zur Verfügung gestellt werden, sondern gegebenenfalls auch angezeigt oder als Fehlerinformation bereit gestellt werden, in welchem Überprüfungs- oder Auswerteschritt welcher Schwellenwert um welchen Betrag über- oder unterschritten wurde. Auf diese Weise können während der Überwachung der elektrischen Anlage nicht nur verschiedene Kenngrößen überprüft und gegebenenfalls das Vorliegen eines Fehlers gemeldet werden, sondern auch ergänzende Informationen zu der Art und gegebenenfalls zu der Schwere des Fehlerereignisses zusammengestellt und zur Verfügung gestellt werden, wodurch eine Behebung des Fehlers und eine möglichst rasche Weiterführung eines fehlerlosen Betriebs der elektrischen Anlage unterstützt und erleichtert wird.

Es kann nicht ausgeschlossen werden, dass beispielsweise zu Beginn eines Gleichstromausgleichsschritts oder eines Wechselstromerfassungsschritts lokale Spannungsspitzen oder flüchtige Ladungskonzentrationen vorliegen, durch welche die Messverfahren beeinträchtigt und gegebenenfalls verfälscht werden könnten. Es kann insbesondere bei sehr niedrig vorgegebenen Schwellenwerten für einen tolerierbaren Potentialdifferenzminimalwert oder für einen Wechselstromschwellenwert nicht ausgeschlossen werden, dass einzelne Störereignisse die Messverfahren beeinträchtigen oder verfälschen. Gemäß einer Ausgestaltung des Erfindungsgedankens kann vorgesehen sein, dass nur dann eine Fehlermeldung erzeugt wird, wenn nach Ablauf einer vorgebbaren Prüfdauer in einem zuletzt durchgeführten Gleichstromauswerteschritt oder in einem zuletzt durchgeführten Wechselstromauswerteschritt das Fehlerstromalarmereignis ausgelöst wurde. Es kann auch vorgesehen sein, dass nur dann eine Fehlermeldung erzeugt wird, wenn bei mehreren aufeinanderfolgend ausgeführten Gleichstromauswerteschritten oder Wechselstromauswerteschritten das Fehlerstromereignis ausgelöst wurde, sodass zeitlich isolierte und mit großer Wahrscheinlichkeit durch ein Störereignis verursachte Fehlerstromereignisse nicht zu einer Fehlermeldung führen müssen.

Insbesondere bei einer Überprüfung der elektrischen Anlage, die über einen längeren Zeitraum oder dauerhaft durchgeführt wird, kann es zweckmäßig sein, dass die wesentlichen Parameter und Kenngrößen der durchgeführten Messungen erfasst und gespeichert werden, um beispielsweise zeitliche Abhängigkeiten und zeitliche Muster bei dem eventuellen Auftreten von Fehlerstromalarmereignissen erkennen zu können, oder um einzelne Fehlerstromalarmereignisse mit externen Ereignissen oder Störungen korrelieren zu können. Es kann deshalb optional vorgesehen sein, dass in einer Prüfschrittspeichereinrichtung für mehrere aufeinanderfolgende Gleichstromausgleichsschritte und/oder für mehrere aufeinanderfolgende Wechselstromerfassungsschritte jeweils mindestens ein für die jeweilige Durchführung vorgegebener Parameter und mindestens eine während oder nach der Durchführung erfasste Kenngröße abgespeichert wird, die mit der in einem Gleichstromausgleichsschritt erfassten Potentialdifferenz oder mit der in einem Wechselstromerfassungsschritt erfassten Wechselstromkenngröße eines Wechselspannungsableitstromflusses korreliert. Bei den Parametern kann es sich beispielsweise um Zeitinformationen über den Beginn und die Dauer einzelner Gleichstromausgleichsschritte, einzelner Ausgleichszeitdauern oder einzelner Ausgleichszeitintervalle, oder über den Beginn und die Dauer einzelner Wechselspannungsprüfschritte handeln. Bei den Kenngrößen kann es sich beispielsweise um die Ergebnisse einzelner Gleichstromüberprüfungsschritte oder Wechselspannungsüberprüfungsschritte handeln, oder um während der Durchführung einzelner Schritte des Verfahrens erfasste Potentialdifferenzen oder Stromstärken oder aber damit korrelierende Spannungswerte bzw. Spannungsamplituden handeln.

Weiterhin kann optional vorgesehen sein, dass die in der Prüfschrittspeichereinrichtung gespeicherten Parameterdaten und Kenngrößendaten einer Prüfschrittauswerteeinrichtung zugeführt werden. Die gespeicherten Parameterdaten oder Kenngrößendaten können in zeitlichen Intervallen, kontinuierlich oder in Reaktion auf eine entsprechende Anfrage an eine Prüfschrittauswerteeinrichtung übertragen werden. Eine zur Verfügung stehende Datenspeichermenge der Prüfschrittspeichereinrichtung kann vergleichsweise klein vorgegeben sein, da die dort gespeicherten Daten in zeitlichen Intervallen automatisiert an die Prüfschrittauswerteeinrichtung übermittelt werden können und die bereits übermittelten Daten wieder mit neuen Parameterdaten oder Kenngrößendaten überschrieben werden können. Die Prüfschrittauswerteeinrichtung kann intern in einer Vorrichtung zum Feststellen eines zu hohen Fehlerstroms einer elektrisch von der Umgebung isoliert zu betreibenden elektrischen Anlage integriert sein. Die Prüfschrittauswerteeinrichtung kann auch extern angeordnet sein, und die Datenübertragung von der Prüfschrittspeichereinrichtung zu der Prüfschrittauswerteeinrichtung kann kabelgebunden oder drahtlos erfolgen, wobei für jede Art der Datenübertragung die jeweils bekannten und gegebenenfalls standardisierten Datenübertragungsverfahren und Datenformate verwendet werden können. Mit Hilfe der Prüfschrittauswerteeinrichtung können einzelne Fehlerstromalarmereignisse oder aber zeitliche Muster von Fehlerstromalarmereignissen oder eventuelle Korrelationen mit internen Betriebszuständen der elektrischen Anlage oder mit externen Ereignissen oder Störeinflüssen untersucht und überprüft werden.

Die Abspeicherung der in der Prüfschrittspeichereinrichtung gespeicherten Parameterdaten kann so vorgegeben werden, dass auch ohne die Auslösung eines Fehlerstromalarmereignisses Kenngrößendaten, die während der Durchführung des Verfahrens erfasst wurden, abgespeichert und für eine anschließende Auswertung zur Verfügung gestellt werden. In zeitlichen Abständen oder aber im Wesentlichen kontinuierlich können dann Kenngrößendaten für einen zurückliegenden Auswertezeitraum mit einer geeigneten Auswerteeinrichtung ausgewertet werden. So können beispielsweise zeitliche Verläufe der erfassten Kenngrößen daraufhin überprüft werden, ob der betreffende zeitliche Verlauf einen Hinweis auf einen vermutlich demnächst eintretenden Fehler in der elektrischen Anlage geben kann. Weiterhin kann auch eine zeitliche Korrelation mit weiteren Ereignissen innerhalb der elektrischen Anlage, beispielsweise einer auftretenden Störung der elektrischen Anlage, oder auch außerhalb der elektrischen Anlage, beispielsweise ein Blitzeinschlag in der Nähe der elektrischen Anlage, vorgenommen und dadurch ein Rückschluss auf eine Fehlerursache ermöglicht werden.

Es kann auch bei einer Auswertung über einen lange zurückliegenden Auswertezeitraum festgestellt werden, dass beispielsweise für einen Ausgleich der zwischenzeitlich immer wieder auftretenden Potentialdifferenzen zwischen dem Umgebungsreferenzpotential einerseits und dem Anlagenreferenzpotential andererseits bzw. für die Gleichstromausgleichsschritte eine immer längere Zeitdauer benötigt wird oder ständig zunehmende Ausgleichsströme erforderlich sind, bis die jeweilige Potentialdifferenz tatsächlich bis unter den vorgegebenen Potentialdifferenzminimalwert reduziert werden konnte. Da dieser Potentialausgleich immer noch gelingt, wird noch kein Fehlerstromalarmereignis ausgelöst. Falls die für den Potentialausgleich benötigte Zeitdauer oder die erforderliche Ausgleichsstromstärke kontinuierlich oder im Mittel systematisch zunimmt, kann jedoch auf ein demnächst drohendes Fehlerereignis geschlossen werden. Durch eine geeignete Auswertung der gespeicherten Kenngrößendaten können gegebenenfalls aussagekräftige Vorhersagen über demnächst drohende Fehlerereignisse erstellt und bei Bedarf geeignete Gegenmaßnahmen ergriffen werden, um ein drohendes Fehlerereignis zu vermeiden und um gegebenenfalls den ungestörten Betrieb der elektrischen Anlage ununterbrochen fortsetzen zu können.

Das erfindungsgemäße Verfahren kann bei Bedarf und ausgelöst von einer Prüfperson durchgeführt werden, um eine elektrische Anlage zu überprüfen. Es kann in vorteilhafter Weise vorgesehen sein, dass das Verfahren dauerhaft in vorgegebenen zeitlichen Abständen zum Nachweisen eines Fehlerstroms einer elektrisch von der Umgebung isoliert zu betreibenden elektrischen Anlage durchgeführt wird. Auf diese Weise kann eine gewünschte oder geforderte elektrische Isolierung einer elektrischen Anlage in zeitlichen Abständen oder im Wesentlichen dauerhaft überprüft und überwacht werden, ohne dass ein ständiger Eingriff oder eine ständige Betreuung durch eine Prüfperson erforderlich sind. Da während der Durchführung des erfindungsgemäßen Verfahrens keine übermäßig hohen Ausgleichsströme oder gegebenenfalls Wechselströme auftreten können und durch eine langfristige Überwachung der elektrischen Anlage das eventuelle Auftreten von Problemen mit der elektrischen Isolierung frühzeitig erkannt werden können, kann eine elektrische Anlage mit dem erfindungsgemäßen Verfahren besonders betriebssicher betrieben werden.

Optional kann insbesondere bei einer lang andauernden oder kontinuierlichen Überwachung einer elektrischen Anlage mit dem vorangehend beschriebenen Verfahren vorgesehen sein, dass eine Durchführung des Verfahrens für eine vorgebbare Pausendauer unterbrochen oder nicht erneut eingeleitet wird. So kann beispielsweise für eine gesondert durchzuführenden Überprüfung der elektrischen Anlage, die ein Gutachter in zeitlichen Abständen vornehmen möchte oder muss, verhindert werden, dass durch diese gesonderte Überprüfung ein Fehlerstromalarmereignis ausgelöst wird, welches nur durch die Überprüfung erzwungen wurde und nicht auf einen möglichen Fehlerstrom zurückgeht. Weiterhin kann durch eine Unterbrechung des Verfahrens verhindert werden, dass eine in einer Pausendauer durchgeführte gesonderte Überprüfung durch das ansonsten zeitgleich durchgeführte Verfahren verfälscht werden könnte.

Die Erfindung betrifft auch eine Vorrichtung zum Feststellen eines zu hohen Fehlerstroms einer elektrisch von der Umgebung isoliert zu betreibenden elektrischen Anlage, wobei die Vorrichtung eine Umgebungsreferenzpotentialkontakteinrichtung aufweist.

Bei den bekannten herkömmlichen Vorrichtungen wird während der Durchführung eines Messvorgangs ein elektrisch leitender Kontakt zwischen der elektrischen Anlage und einem Umgebungsreferenzpotential, beispielsweise einem Erdleiter hergestellt und überprüft, ob ein dann fließender Ausgleichsstrom größer als ein vorgegebener Schwellenwert ist, wobei dieser Schwellenwert üblicherweise dem maximal zulässigen Grenzwert für einen gefährdungsfreien Betrieb der elektrischen Anlage entspricht. Für die Durchführung eines Messvorgangs muss dem zufolge jedes Mal ein vorab unbekannt hoher Ausgleichsstrom und damit ein unsicherer Betriebszustand der elektrischen Anlage in Kauf genommen werden, da anderenfalls nicht überprüft werden kann, ob der tatsächlich fließende Ausgleichsstrom größer als der vorgegebene Schwellenwert ist.

Es wird deshalb als ein weiterer Aspekt der Aufgabe dieser Erfindung angesehen, eine Vorrichtung so für die Durchführung eines Messvorgangs so auszugestalten, dass die Vorgaben für einen gefährdungsfreien Betrieb der elektrischen Anlage auch während der Durchführung eines Messvorgangs zuverlässig eingehalten werden können.

Diese Aufgabe wird erfindungsgemäß dadurch gelöst, dass die Vorrichtung eine Betriebsspannungskontakteinrichtung zum Kontaktieren mit einem Hochpotential und einem relativ dazu niedrigeren Niedrigpotential der elektrischen Anlage aufweist, dass die Vorrichtung einen Spannungsteiler aufweist, der zwischen dem Hochpotential und dem Niedrigpotential der elektrischen Anlage ein Anlagenreferenzpotential zwischen dem Hochpotential und dem Niedrigpotential bereitstellt, dass die Vorrichtung eine Vorzeichenermittlungsverbindung zwischen dem Anlagenreferenzpotential und der Umgebungsreferenzpotentialkontakteinrichtung aufweist, in der eine Potentialdifferenzmesseinrichtung angeordnet ist, sodass mit der Potentialdifferenzmesseinrichtung ein Vorzeichen einer Potentialdifferenz zwischen dem Anlagenreferenzpotential und dem Umgebungsreferenzpotential ermittelbar ist, und dass das Hochpotential und das Niedrigpotential jeweils über eine gesonderte Gleichstromausgleichsleitung mit der Umgebungsreferenzpotentialkontakteinrichtung verbunden sind, wobei eine Hochpotentialgleichstromausgleichleitung einen Hochpotentialschalter aufweist, mit welchem das Hochpotential für eine vorgebbare Ausgleichszeitdauer über einen Gleichstromausgleichswiderstand mit der Umgebungsreferenzpotentialkontakteinrichtung verbindbar ist, und wobei eine Niedrigpotentialgleichstromausgleichleitung einen Niedrigpotentialschalter aufweist, mit welchem das Niedrigpotential für eine vorgebbare Ausgleichszeitdauer über einen Gleichstromausgleichswiderstand mit der Umgebungsreferenzpotentialkontakteinrichtung verbindbar ist. Mit Hilfe der Gleichspannungsmesseinrichtung kann das ermittelt werden, ob das elektrische Anlagenreferenzpotential der elektrischen Anlage höher oder niedriger als das elektrische Umgebungsreferenzpotential beispielsweise eines Erdleiters ist. Es wird dann für eine vorgebbare Ausgleichszeitdauer ein Ausgleichsstrom zugelassen. Die Ausgleichszeitdauer kann in Abhängigkeit von dem vorgegebenen Gleichstromausgleichswiderstand so gering sein, dass der Ausgleichsstrom unterhalb eines Schwellenwerts ist, der für einen gefährdungsfreien elektrisch isolierten Betrieb der elektrischen Anlage vorgegeben ist, sodass auch während der Durchführung einer Messung mit der erfindungsgemäßen Vorrichtung kein unzulässig hoher Ausgleichsstrom fließen kann. Die Ausgleichszeitdauer kann bei der erfindungsgemäßen Vorrichtung beispielsweise als Bruchteil einer Sekunde vorgegeben werden.

Es wird als ein wesentlicher Aspekt und Vorteil der erfindungsgemäßen Vorrichtung angesehen, dass nicht wie bei herkömmlichen Prüfvorrichtungen eine Stromstärke oder eine mit der Stromstärke korrelierende Kenngröße eines Ausgleichsstroms erfasst und mit einem vorgegebenen Schwellenwert verglichen wird, sondern dass über eine vorgebbare Ausgleichszeitdauer ein ausreichend geringer und damit für den Betrieb zulässiger Ausgleichsstrom vorgegeben wird und anschließend überprüft wird, ob eine eventuell bestehende Potentialdifferenz zwischen dem Anlagenreferenzpotential der elektrischen Anlage und einem Umgebungsreferenzpotential ausgeglichen bzw. unter einen vorgebbaren Potentialdifferenzminimalwert gesenkt werden konnte. Die erfindungsgemäße Vorrichtung kann damit sowohl kurzzeitig im Bedarfsfall als auch längerfristig oder dauerhaft zur Überprüfung einer elektrischen Anlage verwendet werden, ohne dass potentiell gegen die für einen gefährdungsfreien Betrieb der elektrischen Anlage vorgegebenen Auflagen oder Vorgaben verstoßen werden muss.

Ausgehend von dem Gleichstromausgleichswiderstand der Vorrichtung kann in Abhängigkeit von einer ermittelten Potentialdifferenz zwischen dem Anlagenreferenzpotential der elektrischen Anlage und dem Umgebungsreferenzpotential eine maximal zulässige Ausgleichszeitdauer ermittelt und vorgegeben werden, mit welcher eine Stromstärke des Ausgleichsstroms begrenzt wird. An Stelle einer Potentialdifferenz kann auch ein tatsächlich fließender Ausgleichsstrom oder eine mit einer Stromstärke des Ausgleichsstroms korrelierende Kenngröße ermittelt und für die Vorgabe einer maximal zulässigen Ausgleichszeitdauer verwendet werden. Es ist deshalb optional vorgesehen, dass die Vorrichtung eine Kontrolleinrichtung aufweist, mit welcher ein über die Hochpotentialgleichstromausgleichleitung oder über die Niedrigpotentialgleichstromausgleichleitung jeweils bei geschlossenem Hochpotentialschalter bzw. Niedrigpotentialschalter fließender Ausgleichsstrom erfassbar ist, und mit welcher die Ausgleichszeitdauer vorgebbar ist.

Bei einer größeren Potentialdifferenz zwischen der elektrischen Anlage und dem Umgebungsreferenzpotential kann es vorkommen, dass für die Angleichung der elektrischen Potentiale eine Ausgleichszeitdauer erforderlich ist, die zu einem zu großen Ausgleichsstrom führen würde. Insbesondere in solchen Situationen kann es zweckmäßig sein, dass die Kontrolleinrichtung derart eingerichtet ist, dass die Kontrolleinrichtung eine Anzahl von Ausgleichszeitintervallen mit einer Ausgleichszeitintervalldauer vorgeben kann, welche in Summe die Ausgleichszeitdauer bilden, jedoch über die Messdauer hinweg so zeitlich beabstandet verteilt sind, dass die in den Ausgleichszeitintervallen maximal fließenden Ladungsmengen unterhalb eines kontinuierlich fließenden Ausgleichsmaximalstroms bleiben. Einer Ausgestaltung des Erfindungsgedankens zufolge ist deshalb optional vorgesehen, dass die Kontrolleinrichtung derart eingerichtet ist, dass die Kontrolleinrichtung in Abhängigkeit von dem jeweils erfassten Ausgleichsstrom eine wechselnde Anzahl von Ausgleichszeitintervallen vorgeben kann. Die Kontrolleinrichtung kann gegebenenfalls auch eine Dauer der einzelnen Ausgleichszeitintervalle beeinflussen und vorgeben.

Um eine Auswertung einzelner oder mehrerer Messvorgänge zu ermöglichen oder zu erleichtern, die mit der Vorrichtung durchgeführt werden, ist optional vorgesehen, dass die Vorrichtung eine Prüfschrittspeichereinrichtung aufweist, in welcher für mehrere aufeinanderfolgende Gleichstromausgleichsschritte und/oder für mehrere aufeinanderfolgende Wechselstromerfassungsschritte jeweils mindestens ein für die jeweilige Durchführung vorgegebener Parameter und mindestens eine während oder nach der Durchführung erfasste Kenngröße abspeicherbar ist.

In vorteilhafter Weise ist vorgesehen, dass die Vorrichtung eine Warnsignaleinrichtung aufweist, mit welcher für unterschiedlich ausgelöste Fehlerstromalarmereignisse optisch oder akustisch unterschiedliche Warninformationen erzeugt und angezeigt bzw. ausgesendet werden können. Es kann auch vorgesehen sein, dass die Vorrichtung eine Kenngrößenverlaufsanzeigeeinrichtung aufweist, mit welcher eine Anzahl von Kenngrößen, die gegebenenfalls zuvor mit der Prüfschrittspeichereinrichtung oder mit einer gesonderten Kenngrößenverlaufspeichereinrichtung abgespeichert wurden, angezeigt und dadurch ein zeitlicher Verlauf der betreffenden Kenngrößen veranschaulicht wird.

Einer besonders vorteilhaften Ausgestaltung des Erfindungsgedankens zufolge ist vorgesehen, dass die Vorrichtung für die Durchführung des vorangehend beschriebenen Verfahrens eingerichtet ist. Die Vorrichtung kann für diesen Zweck weitere Komponenten aufweisen, die im Zusammenhang mit einzelnen Aspekten des erfindungsgemäßen Verfahrens erwähnt sind oder geeignet sind.

Nachfolgend werden einige Ausführungsbeispiele des Erfindungsgedankens näher erläutert, die in den Zeichnungen exemplarisch und schematisch dargestellt sind. Es zeigt:
Fig. 1 eine schematische Ansicht eines mit einem Erdleiter verbundenen Haushaltsversorgungsstromkreises und einer davon elektrisch isoliert angeordneten und betriebenen elektrischen Anlage,
Fig. 2 die in Fig. 1 gezeigte Ansicht des Haushaltsversorgungsstromkreises und der elektrisch isoliert betriebenen elektrischen Anlage sowie eine elektrisch leitend sowohl mit dem Erdleiter des Haushaltsversorgungsstromkreises als auch mit der elektrischen Anlage verbundene Vorrichtung zum Feststellen eines zu hohen Fehlerstroms der elektrisch von der Umgebung isoliert zu betreibenden elektrischen Anlage,
Fig. 3 eine schematische Schaltskizze der Vorrichtung zum Feststellen eines zu hohen Fehlerstroms einer elektrisch von der Umgebung isoliert zu betreibenden elektrischen Anlage, mit welcher ein Gleichstromüberprüfungsschritt durchgeführt werden kann,
Fig. 4 eine schematische Schaltskizze der Vorrichtung in einer Ausgestaltung, mit welcher zusätzlich auch ein Wechselspannungsprüfschritt durchgeführt werden kann,
Fig. 5 eine schematische Darstellung eines Flussdiagramms für einen exemplarisch dargestellten Verfahrensablauf für ein Verfahren zum Feststellen eines zu hohen Fehlerstroms einer elektrisch von der Umgebung isoliert zu betreibenden elektrischen Anlage,
Fig. 6 eine schematische Darstellung eines zeitlichen Verlaufs einer Potentialdifferenz zwischen einem Umgebungsreferenzpotential und einem Anlagenreferenzpotential der elektrischen Anlage sowie eines zeitlichen Verlaufs eines Ausgleichsstroms während mehrerer aufeinanderfolgender Gleichstromausgleichsschritte innerhalb des in Fig. 5 schematisch dargestellten Verfahrens, und
Fig. 7 eine schematische Darstellung eines zeitlichen Verlaufs eines Ausgleichsstroms während mehrerer aufeinanderfolgender Gleichstromausgleichsschritte mit jeweils mehreren Ausgleichszeitintervallen innerhalb des in Fig. 5 schematisch dargestellten Verfahrens.

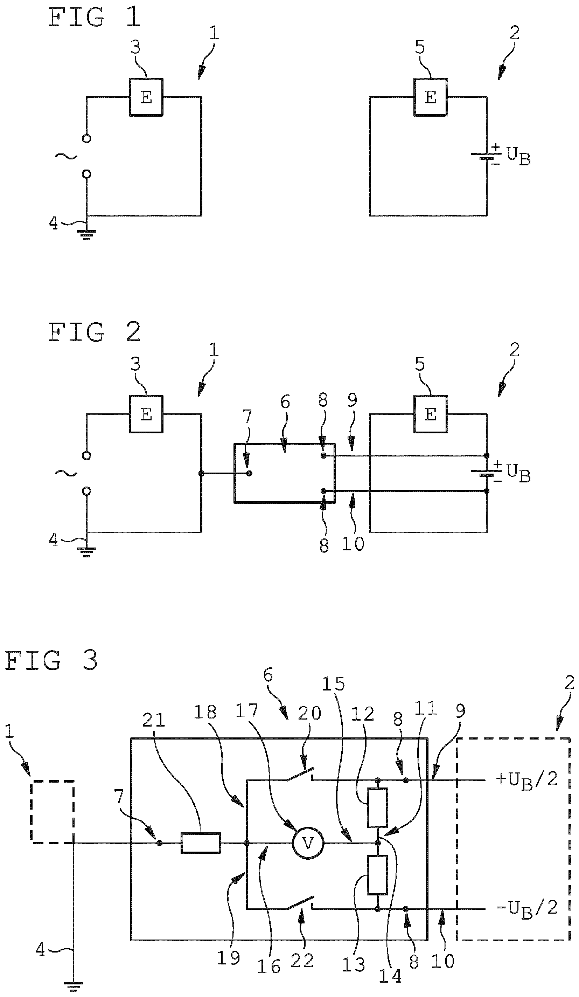

In den Fig. 1 und 2 sind schematisch jeweils ein Haushaltsversorgungsstromkreis 1 und eine davon elektrisch isoliert angeordnete und betriebene elektrische Anlage 2 dargestellt. Der Haushaltsversorgungsstromkreis 1 kann einen oder mehrere elektrische Verbraucher 3 beinhalten und wird beispielsweise mit einer haushaltsüblichen Wechselspannung von 230 V und 50 Hz betrieben. Der Haushaltsversorgungsstromkreis 1 weist einen Erdleiter 4 auf. Für elektrische Verbraucher 3, die in geeigneter Weise mit den Haushaltsversorgungsstromkreis 1 verbunden sind, kann durch eine Verbindung mit dem Erdleiter 4 verhindert werden, dass sich in einem elektrischen Verbraucher 3 ein elektrisches Potential aufbaut, welches für die Umgebung oder insbesondere für Personen gefährlich sein könnte.

Die elektrisch isoliert angeordnete und betriebene elektrische Anlage 2 kann eine Patientenrufanlage in einem Krankenhaus sein, wobei beispielsweise Rufauslöseeinrichtungen und Rufanzeigeeinrichtungen elektrische Verbraucher 5 in der elektrischen Anlage 2 sind. Eine Patientenrufanlage muss zum Schutz der Patienten, deren Handlungsfreiheit eingeschränkt sein kann, besondere Anforderungen an die elektrische Sicherheit erfüllen. Eine Patientenrufanlage wird üblicherweise elektrisch isoliert und elektrisch abgeschirmt von anderen elektrischen Versorgungsstromkreisen mit einer erdpotenzialfreien Schutzkleinspannung betrieben, die auch als Sicherheitskleinspannung bzw. als SELV (Safety Extra Low Voltage) bezeichnet wird. Trotz aller Schutzmaßnahmen kann nicht ausgeschlossen werden, dass beispielsweise durch unvorhergesehene Ladungsansammlungen innerhalb des Haushaltsversorgungsstromkreises 1, durch externe Einflüsse oder durch Fehler bzw. Beschädigungen einer elektrischen Isolation elektrische Felder und Ladungsansammlungen entstehen, die sich nachteilig auf den Betrieb der Patientenrufanlage bzw. der elektrischen Anlage 2 und insbesondere auf deren Sicherheit auswirken können. Eine in der Praxis häufig auftretende unerwünschte Auswirkung kann sein, dass sich ein elektrisches Anlagenreferenzpotential, welches einen Potentialwert zwischen einem höchsten Potentialwert und einem niedrigsten Potentialwert der elektrischen Anlage 2 aufweist, durch unbeabsichtigte Einflüsse zunehmend von einem Umgebungsreferenzpotentialwert unterscheidet, der beispielsweise durch den Erdleiter 4 des Haushaltsversorgungsstromkreis 1 vorgegeben ist. Im Falle eines Isolationsfehlers innerhalb der elektrischen Anlage 2 könnte dann über eine Person ein als Fehlerstrom bezeichneter Ausgleichsstrom fließen, mit welchem das Anlagenreferenzpotential an das Umgebungsreferenzpotential bzw. in dem gezeigten Ausführungsbeispiel an das Potential des Erdleiters 4 angeglichen wird. Bei größeren Ladungsansammlungen und Potentialdifferenzen könnte dieser Fehlerstrom für Personen gefährlich werden und sollte deshalb verhindert werden können. Diese Überlegungen treffen auf beliebige elektrisch isoliert betriebene elektrische Anlagen 2 zu, für welche Sicherheitsmaßnahmen zum Schutz von Personen relevant sind.

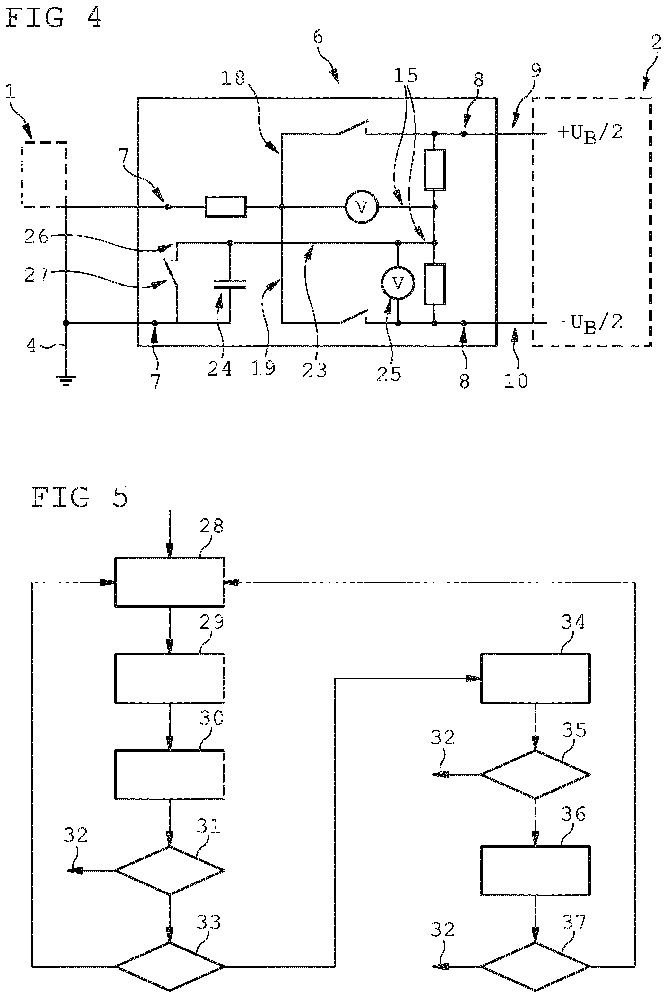

Um während des Betriebs der elektrischen Anlage 2 feststellen und überwachen zu können, ob gegebenenfalls ein Fehlerstrom fließen könnte, dessen Stromstärke oder Spannung oberhalb eines vorgebbaren Fehlerstromkriteriums liegt, kann wie in Fig. 2 schematisch dargestellt eine Vorrichtung 6 zum Feststellen eines zu hohen Fehlerstroms der elektrisch von der Umgebung isoliert zu betreibenden elektrischen Anlage 2 verwendet werden, für welche schematische Schaltbilder in Fig. 3 und in Fig. 4 dargestellt sind. Die Vorrichtung 6 weist eine Umgebungsreferenzpotentialkontakteinrichtung 7 zum elektrisch leitenden Kontaktieren mit einem Umgebungsreferenzpotential, beispielsweise mit dem Erdleiter 4, sowie eine Betriebsspannungskontakteinrichtung 8 zum Kontaktieren mit einem Hochpotential 9 und einem relativ dazu niedrigeren Niedrigpotential 10 der elektrischen Anlage 2 auf. Die Vorrichtung 6 kann dauerhaft sowohl mit dem Erdleiter 4 als auch mit dem Hochpotential 9 und dem Niedrigpotential 10 der elektrischen Anlage 2 verbunden sein, da eine in der Vorrichtung 6 vorgegebene galvanische Trennung der Umgebungsreferenzpotentialkontakteinrichtung 7 einerseits von der Betriebsspannungskontakteinrichtung 8 der elektrischen Anlage 2 andererseits nur sehr kurzzeitig überbrückt wird, sodass keine Fehlerströme oberhalb eines vorgebbaren Fehlerstromkriteriums zwischen der elektrischen Anlage 2 und dem Erdleiter 4 fließen können.

Die Vorrichtung 6 weist einen Spannungsteiler 11 mit zwei ohmschen Widerständen 12, 13 auf, der zwischen dem Hochpotential 9 und dem Niedrigpotential 10 der elektrischen Anlage 2 in einem Leitungsabschnitt 14 zwischen den beiden in Reihe geschalteten ohmschen Widerständen 12, 13 ein Anlagenreferenzpotential 15 zwischen dem Hochpotential 9 und dem Niedrigpotential 10 bereitstellt. Bei gleich großen ohmschen Widerständen 12, 13 entspricht das Anlagenreferenzpotential 15 einem arithmetischen Mittelwert zwischen dem Hochpotential 9 und dem Niedrigpotential 10. Der Spannungsteiler 11 könnte auch abweichend davon ausgestaltet sein und ein Anlagenreferenzpotential 15 bereitstellen, welches einem dadurch vorgegebenen Potentialwert zwischen dem Hochpotential 9 und dem Niedrigpotential 10 entspricht.

Die Vorrichtung 6 weist eine Vorzeichenermittlungsverbindung 16 zwischen dem Anlagenreferenzpotential 15 und der Umgebungsreferenzpotentialkontakteinrichtung 7 auf, in der eine Potentialdifferenzmesseinrichtung 17 angeordnet ist, sodass mit der Potentialdifferenzmesseinrichtung 17 ein Vorzeichen einer Potentialdifferenz zwischen dem Anlagenreferenzpotential 15 und dem Umgebungsreferenzpotential bzw. dem Erdleiter 4 ermittelt werden kann.

Das Hochpotential 9 und das Niedrigpotential 10 sind jeweils über eine gesonderte Gleichstromausgleichsleitung 18, 19 mit der Umgebungsreferenzpotentialkontakteinrichtung 7 verbunden. Die Hochpotentialgleichstromausgleichleitung 18 weist einen Hochpotentialschalter 20 auf, mit welchem das Hochpotential 9 für eine vorgebbare Ausgleichszeitdauer über einen Gleichstromausgleichswiderstand 21 mit der Umgebungsreferenzpotentialkontakteinrichtung 7 verbunden werden kann. In gleicher Weise weist die Niedrigpotentialgleichstromausgleichleitung 19 einen Niedrigpotentialschalter 22 auf, mit welchem das Niedrigpotential 10 für eine vorgebbare Ausgleichszeitdauer über einen Gleichstromausgleichswiderstand 21 mit der Umgebungsreferenzpotentialkontakteinrichtung 7 verbunden werden kann. Bei dem in den Fig. 3 und 4 dargestellten Ausführungsbeispiel ist der Gleichstromausgleichswiderstand 21 der Hochpotentialgleichstromausgleichsleitung 18 derselbe, bzw. identisch mit dem Gleichstromausgleichswiderstand 21 der Niedrigpotentialgleichstromausgleichsleitung 19.

In Fig. 4 ist schematisch eine Schaltskizze einer abweichend ausgestalteten Vorrichtung 6 dargestellt, mit welcher zusätzlich auch der Einfluss einer in oder durch die Umgebung erzeugten Wechselspannung auf die elektrisch isoliert betriebene elektrische Anlage 2 und die dadurch möglicherweise verursachten Fehlerströme erfasst werden können. In Fig. 4 sind zur Verdeutlichung überwiegend Komponenten mit Bezugszeichen versehen und nachfolgend erläutert, die zusätzlich zu den aus Fig. 3 bekannten Komponenten in der Vorrichtung 6 angeordnet oder relevant sind.

Zu diesem Zweck weist die Vorrichtung 6 eine Wechselspannungsmessleitung 23 auf, welche unabhängig von den Gleichstromausgleichsleitungen 18, 19 das Anlagenreferenzpotential 15 mit der Umgebungsreferenzpotentialkontakteinrichtung 7 verbindet. In der Wechselspannungsmessleitung 23 ist ein Wechselspannungsmesskondensator 24 angeordnet, der eine galvanische Trennung zwischen dem Anlagenreferenzpotential 15 und der Umgebungsreferenzpotentialkontakteinrichtung 7 bewirkt. Zwischen der Wechselspannungsmessleitung 23 und dem Niedrigpotential 10 ist eine weitere Potentialdifferenzmesseinrichtung 25 angeordnet, mit welcher eine zeitlich stark schwankende Potentialdifferenz zwischen dem Niedrigpotential 10 und dem Wechselspannungsmesskondensator 24 bzw. dem von dem Wechselspannungsmesskondensator 24 beeinflussten Anlagenreferenzpotential 15 erfasst werden kann. Wenn die mit der Potentialdifferenzmesseinrichtung 25 erfasste Potentialdifferenz ausreichend gering ist, sodass kein übermäßig hoher Fehlerstrom befürchtet werden muss, kann der Wechselspannungsmesskondensator 24 über eine Bypassleitung 26 überbrückt werden, die mit einem Bypassschalter 27 elektrisch leitend geschaltet oder unterbrochen werden kann.

Ein erfindungsgemäßer Verfahrensablauf zum Feststellen eines zu hohen Fehlerstroms der elektrisch von der Umgebung isoliert zu betreibenden elektrischen Anlage 2 mit den in den Fig. 3 oder Fig. 4 dargestellten Vorrichtungen 6 ist schematisch in Fig. 5 dargestellt.

In einem Vorzeichenermittlungsschritt 28 wird mit der Potentialdifferenzmesseinrichtung 17 eine elektrische Potentialdifferenz zwischen dem Umgebungsreferenzpotential an der Umgebungsreferenzpotentialkontakteinrichtung 7 und dem Anlagenreferenzpotential 15 der elektrischen Anlage 2 erfasst.

In einem gegebenenfalls mehrfach hintereinander durchgeführten Gleichstromausgleichsschritt 29 wird in Abhängigkeit von einem Ausgleichsvorzeichen der in dem Vorzeichenermittlungsschritt 28 erfassten Potentialdifferenz das Umgebungsreferenzpotential bzw. die Umgebungsreferenzpotentialkontakteinrichtung 7 über den Gleichstromausgleichwiderstand 21 für eine vorgebbare Ausgleichszeitdauer entweder mit dem gegenüber dem Anlagenreferenzpotential 15 höheren Hochpotential 9 oder dem niedrigeren Niedrigpotential 10 der elektrischen Anlage 2 elektrisch leitend verbunden, indem der jeweils zugeordnete Hochpotentialschalter 20 oder der Niedrigpotentialschalter 22 geschlossen und eine elektrisch leitende Verbindung hergestellt wird, um durch einen durch den

Gleichstromausgleichwiderstand 21 fließenden Ausgleichsstrom die Potentialdifferenz zwischen dem Umgebungsreferenzpotential und dem Anlagenreferenzpotential 15 der elektrischen Anlage 2 zu reduzieren. Die vorgegebene Ausgleichszeitdauer ist dabei kürzer als eine Grenzzeitdauer, bei welcher eine durch den Gleichstromausgleichwiderstand 21 fließende Ladungsmenge einem vorgebbaren kontinuierlich fließenden Ausgleichsmaximalstrom entspricht. Bei Patientenrufanlagen wird beispielsweise gefordert, dass ein maximal zulässiger Fehlerstrom eine Stromstärke unterhalb von 50 µA haben muss. Bei einer Anlagenspannung UB von 24V kann der Gleichstromausgleichwiderstand 21 mit 120 kOhm vorgegeben werden. Durch ein Einschaltverhältnis für den über den Gleichstromausgleichwiderstand 21 dann maximal fließenden Ausgleichsstrom von 24V / 120 kOhm = 200pA von bis zu 5% der Messdauer kann erreicht werden, dass die maximal erzeugte Ladungsverschiebung einem Ausgleichsmaximalstrom mit einer Stromstärke von 10 µA entspricht.

In einem Gleichstromüberprüfungsschritt 30 wird überprüft, ob innerhalb einer vorgebbaren Ausgleichsmessdauer mit gegebenenfalls mehreren Gleichstromausgleichsschritten 29 in dem zuletzt durchgeführten Gleichstromausgleichsschritt 29 mit dem Ausgleichsstrom die mit der Potentialdifferenzmesseinrichtung 17 erfasste Potentialdifferenz zwischen dem Umgebungsreferenzpotential bzw. der Umgebungsreferenzpotentialkontakteinrichtung 7 und dem Anlagenreferenzpotential 15 unter einen vorgebbaren Potentialdifferenzminimalwert reduziert wurde, oder ob die Potentialdifferenz zwischen dem Umgebungsreferenzpotential und dem Anlagenreferenzpotential 15 mit dem Ausgleichsstrom nicht unter einen vorgebbaren Potentialdifferenzminimalwert gesenkt werden konnte.

In einem Gleichstromauswertschritt 31 wird ausgehend von einem Ergebnis des Gleichstromüberprüfungsschritts 30 ein Fehlerstromalarmereignis 32 ausgelöst, wenn in dem zuletzt durchgeführten Gleichstromausgleichsschritt 29 mit dem Ausgleichsstrom die Potentialdifferenz zwischen dem Umgebungsreferenzpotential und dem Anlagenreferenzpotential 15 nicht unter einen vorgebbaren Potentialdifferenzminimalwert gesenkt werden konnte. Ansonsten kann das Verfahren fortgesetzt werden. In einem Prüfverfahrenauswahlschritt 33 wird üblicherweise vorgegeben, dass das bisher beschriebene Verfahren erneut durchgeführt und mit dem erneut durchzuführenden Vorzeichenermittlungsschritt 28 fortgesetzt wird. In vorgebbaren zeitlichen Abständen von beispielsweise 60 Sekunden, was in dem Prüfverfahrenauswahlschritt ermittelt wird, wird nicht erneut ein Vorzeichenermittlungsschritt 28, sondern die Durchführung eines Wechselspannungsmessschritts 34 und eines nachfolgenden Wechselspannungsprüfungsschritts 35 vorgegeben.

In dem Wechselspannungsmessschritt 34 wird mit der Potentialdifferenzmesseinrichtung 25 über eine vorgebbare Wechselspannungsprüfdauer eine Wechselspannungspotentialdifferenz zwischen dem Anlagenreferenzpotential 15 und dem Niedrigpotential 10 erfasst. In dem Wechselspannungsprüfungsschritt 35 wird überprüft, ob während der Wechselspannungsprüfdauer eine zwischen dem Anlagenreferenzpotential 15 und dem Niedrigpotential 10 innerhalb der elektrischen Anlage 2 mit der Potentialdifferenzmesseinrichtung 25 erfasste Wechselspannungspotentialdifferenz größer als ein vorgebbarer Wechselspannungsfehlerschwellenwert wird. Ist das der Fall, so wird ein Fehlerstromalarmereignis 32 ausgelöst und das Verfahren abgebrochen. Es kann gegebenenfalls mit einer erneuten Durchführung des Vorzeichenermittlungsschritts 28 fortgesetzt werden. Der Wechselspannungsmesskondensator 24 wird dann nicht über eine Bypassleitung 26 überbrückt bzw. der Bypassschalter 27 nicht geschlossen und keine elektrisch leitende Verbindung zwischen dem Anlagenreferenzpotential 15 und dem Umgebungsreferenzpotential hergestellt, was zu einem übermäßig hohen Ableitstromfluss zwischen der elektrischen Anlage 2 und dem Umgebungsreferenzpotential bzw. dem Erdleiter 4 führen könnte.

Wenn die mit der Potentialdifferenzmesseinrichtung 25 erfasste Wechselspannungspotentialdifferenz kleiner als ein vorgebbarer Wechselspannungsfehlerschwellenwert ist, wird ein Wechselstromerfassungsschritt 36 durchgeführt, in welchem der Bypassschalter 27 geschlossen und mit der Potentialdifferenzmesseinrichtung 25 eine mit einer Stromstärke korrelierende Wechselstromkenngröße eines Wechselspannungsableitstromflusses erfasst wird, der durch einen von einem der beiden ohmschen Widerständen 12, 13 gebildeten Wechselspannungsmesswiderstand 36 und den mit der Bypassleitung 26 überbrückten Wechselspannungsmesskondensator 24 zwischen der elektrischen Anlage 2 und dem Umgebungsreferenzpotential bzw. dem Erdleiter 4 fließt.

In einem nachfolgenden Wechselstromauswerteschritt 37 wird dann ausgehend von der mit dem Wechselstromerfassungsschritt 36 erfassten Wechselstromkenngröße ein Fehlerstromalarmereignis 32 ausgelöst, wenn die Wechselstromkenngröße größer als ein vorgegebener Wechselstromschwellenwert ist.

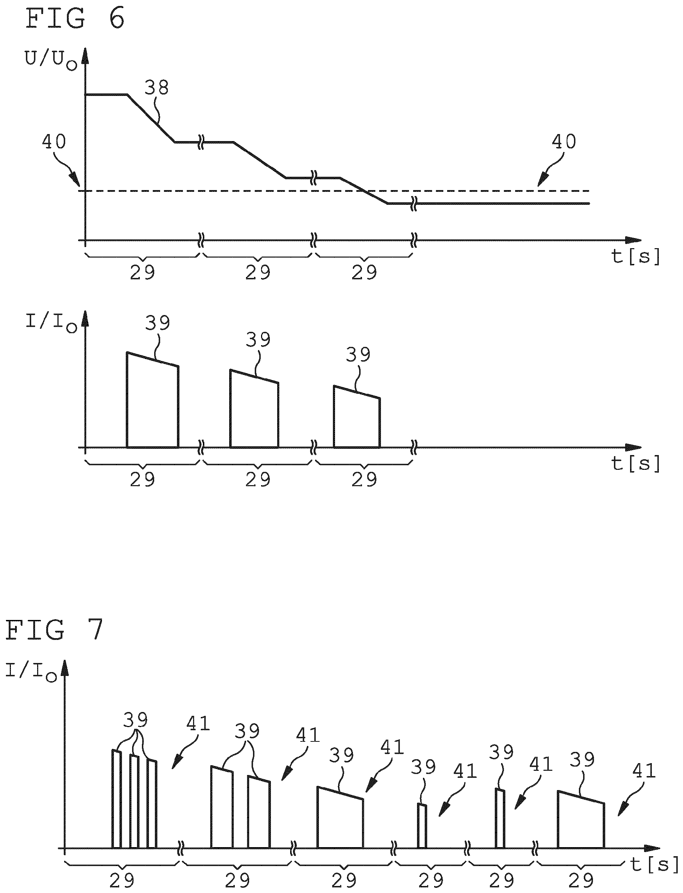

In Fig. 6 ist schematisch ein zeitlicher Verlauf einer auf einen Einheitswert U/U₀ normierten Potentialdifferenz 38 zwischen dem Umgebungsreferenzpotential und dem Anlagenreferenzpotential 15 der elektrischen Anlage 2 sowie zeitlich korrelierend der zeitliche Verlauf eines ebenfalls auf einen Einheitswert I/I₀ normierten Ausgleichsstroms 39 während mehrerer aufeinanderfolgender Gleichstromausgleichsschritte 29 innerhalb des in Fig. 5 schematisch dargestellten Verfahrensablaufs dargestellt. Eine zunächst noch große Potentialdifferenz 38 wird mit jedem aufeinanderfolgenden Gleichstromausgleichsschritt 29 reduziert, bis die reduzierte Potentialdifferenz 38 auf einen Wert unterhalb des Potentialdifferenzminimalwerts 40 absinkt und kein weiterer Gleichstromausgleichsschritt 29 erforderlich ist, bis ein erneuter Prüfzyklus durchgeführt wird.

Für den Gleichstromüberprüfungsschritt 30 und den Wechselspannungsprüfungsschritt 35 bzw. auch den Wechselstromerauswerteschritt 37 können unterschiedliche Schwellenwerte für die jeweilige Auslösung eines Fehlerstromalarmereignisses 32 vorgegeben werden. In vielen Anwendungsfällen ist dies auch zweckmäßig und vorteilhaft. Auf diese Weise kann berücksichtigt werden, dass die Vorrichtung 6 für die Gleichstromüberprüfung und für die Wechselspannungsüberprüfung unterschiedliche und an die jeweilige Messsituation angepasste Komponenten aufweisen kann sowie entsprechende individuell vorgegebene Kenngrößen erfasst. Zusätzlich kann auch auf unterschiedliche gesetzliche oder normierte Vorgaben bei der Überprüfung elektrischer Anlagen eingegangen und die jeweiligen Grenzwerte berücksichtigt und überprüft werden. Das Fehlerstromalarmereignis 32 kann in Abhängigkeit von der das jeweilige Fehlerstromalarmereignis 32 auslösenden Messung oder Kenngröße unterschiedliche Anzeigen oder Warnsignale erzeugen, die entweder unmittelbar mit der Vorrichtung 6 angezeigt oder erzeugt werden, oder aber unterschiedliche Fehlerinformationen bzw. Warninformationen an eine externe oder zentrale Auswerteeinrichtung und Alarmsignalerzeugungseinrichtung übermitteln. Auf diese Weise kann bei der Durchführung des Verfahrens und einer Auslösung eines Fehlerstromalarmereignisses 32 mit angezeigt und von einem Empfänger der Fehler- oder Warninformationen unterschieden werden, welche Art von Fehler vorliegt und mit der Vorrichtung 6 erfasst wurde.

Fig. 7 zeigt eine schematische Darstellung eines exemplarischen zeitlichen Verlaufs des Ausgleichsstroms 39 während mehrerer aufeinanderfolgender Gleichstromausgleichsschritte 29, wobei jeder Gleichstromausgleichsschritt 29 jeweils eine Anzahl von mehreren Ausgleichszeitintervallen 41 umfasst, die innerhalb des jeweiligen Gleichstromausgleichsschritts 29 vorgegeben sind. Die für einen Gleichstromausgleichsschritt 29 vorgegebene Ausgleichszeitdauer kann dabei beispielsweise in Abhängigkeit von der jeweils unmittelbar zuvor ermittelten Potentialdifferenz 38 auf eine unterschiedliche Anzahl von Ausgleichszeitintervallen 41 aufgeteilt werden. Zudem kann die Ausgleichszeitdauer von aufeinanderfolgenden Gleichstromausgleichsschritten 29 unabhängig von einer Aufteilung in Ausgleichszeitintervalle 41 unterschiedlich lang vorgegeben werden, sodass beispielsweise bei einer zuvor ermittelten Potentialdifferenz 38 deutlich unterhalb des Potentialdifferenzminimalwerts 40 nur eine vergleichsweise kurze Ausgleichszeitdauer mit nur einem einzigen kurzen Ausgleichszeitintervall 41 vorgegeben wird, bis eine Zunahme der Potentialdifferenz 38 festgestellt wird und eine umfangreichere bzw. genauere Prüfung erforderlich wird.

## Patentansprüche

1. Verfahren zum Feststellen eines zu hohen Fehlerstroms einer elektrisch von der Umgebung isoliert zu betreibenden elektrischen Anlage (2), wobei in einem Vorzeichenermittlungsschritt (28) eine elektrische Potentialdifferenz (38) zwischen einem Umgebungsreferenzpotential und einem Anlagenreferenzpotential (15) der elektrischen Anlage (2) erfasst wird, wobei das Anlagenreferenzpotential (15) einem Potentialwert zwischen einem höheren Hochpotential (9) und einem relativ dazu niedrigeren Niedrigpotential (10) der elektrischen Anlage (2) entspricht, wobei in einem gegebenenfalls mehrfach hintereinander durchgeführten Gleichstromausgleichsschritt (29) in Abhängigkeit von einem Ausgleichsvorzeichen der in dem Vorzeichenermittlungsschritt (28) erfassten Potentialdifferenz (38) das Umgebungsreferenzpotential über einen Gleichstromausgleichwiderstand (21) für eine vorgebbare Ausgleichszeitdauer entweder mit dem gegenüber dem Anlagenreferenzpotential (15) höheren Hochpotential (9) oder dem niedrigeren Niedrigpotential (10) der elektrischen Anlage (2) elektrisch leitend verbunden wird, um durch einen durch den Gleichstromausgleichwiderstand (21) fließenden Ausgleichsstrom die Potentialdifferenz (38) zwischen dem Umgebungsreferenzpotential und dem Anlagenreferenzpotential (15) der elektrischen Anlage (2) zu reduzieren, wobei die vorgegebene Ausgleichszeitdauer kürzer als eine Grenzzeitdauer ist, bei welcher eine durch den Gleichstromausgleichwiderstand (21) fließende Ladungsmenge einem vorgebbaren kontinuierlich fließenden Ausgleichsmaximalstrom entspricht, dass in einem Gleichstromüberprüfungsschritt (30) überprüft wird, ob innerhalb einer vorgebbaren Ausgleichsmessdauer mit gegebenenfalls mehreren Gleichstromausgleichsschritten (29) in dem zuletzt durchgeführten Gleichstromausgleichsschritt (29) mit dem Ausgleichsstrom die mit einer Potentialdifferenzmesseinrichtung (17) erfasste Potentialdifferenz (38) zwischen dem Umgebungsreferenzpotential und dem Anlagenreferenzpotential (15) unter einen vorgebbaren Potentialdifferenzminimalwert (40) reduziert wurde, oder ob die Potentialdifferenz (38) zwischen dem Umgebungsreferenzpotential und dem Anlagenreferenzpotential (15) mit dem Ausgleichsstrom nicht unter einen vorgebbaren Potentialdifferenzminimalwert (40) gesenkt werden konnte, und dass in einem Gleichstromauswertschritt (31) ausgehend von einem Ergebnis des Gleichstromüberprüfungsschritts (30) ein Fehlerstromalarmereignis (32) ausgelöst wird, wenn in dem zuletzt durchgeführten Gleichstromausgleichsschritt (29) mit dem Ausgleichsstrom die Potentialdifferenz (38) zwischen dem Umgebungsreferenzpotential und dem Anlagenreferenzpotential (15) nicht unter den vorgebbaren Potentialdifferenzminimalwert (40) gesenkt werden konnte.

2. Verfahren nach Anspruch 1, **dadurch gekennzeichnet, dass** das Hochpotential (9) der elektrischen Anlage (2) dem höchsten elektrischen Potential innerhalb der elektrischen Anlage (2) entspricht, und dass das Niedrigpotential (10) der elektrischen Anlage (2) dem niedrigsten elektrischen Potential innerhalb der elektrischen Anlage (2) entspricht.

3. Verfahren nach Anspruch 1 oder Anspruch 2, **dadurch gekennzeichnet, dass** in dem Gleichstromausgleichsschritt (29) die Ausgleichszeitdauer als Summe von mehreren aufeinanderfolgenden Ausgleichszeitintervallen (41) vorgegeben wird, während der das Umgebungsreferenzpotential über den Gleichstromausgleichwiderstand (21) entweder mit dem gegenüber dem Umgebungsreferenzpotential höheren Hochpotential (9) oder dem niedrigeren Niedrigpotential (10) der elektrischen Anlage (2) elektrisch leitend verbunden ist.

4. Verfahren nach einem der vorangehenden Ansprüche, **dadurch gekennzeichnet, dass** in einem Langzeitausgleichsschritt nacheinander mehrere Gleichstromausgleichsschritte (29) durchgeführt werden, dass für jeden Gleichstromausgleichsschritt (29) ein Gleichstromüberprüfungsschritt (30) durchgeführt wird und dass der Gleichstromauswerteschritt (31) ausgehend von dem Ergebnis des Gleichstromüberprüfungsschritts (30) des zuletzt in dem Langzeitausgleichsschritt durchgeführten Gleichstromausgleichsschritt (29) durchgeführt wird.

5. Verfahren nach Anspruch 4, **dadurch gekennzeichnet, dass** während des Langzeitausgleichsschritts für einen ersten oder vorausgehenden Gleichstromausgleichsschritt (29) eine erste Ausgleichszeitdauer vorgegeben wird, und dass für einen nachfolgenden Gleichstromausgleichsschritt (29) eine zweite Ausgleichszeitdauer vorgegeben wird, die länger als die erste Ausgleichszeitdauer ist, wenn in dem Gleichstromüberprüfungsschritt (30) festgestellt wurde, dass innerhalb des ersten oder vorausgehenden Gleichstromausgleichsschritts (29) mit dem Ausgleichsstrom die Potentialdifferenz (38) zwischen dem Umgebungsreferenzpotential und dem Anlagenreferenzpotential (15) nicht unter den vorgegebenen Potentialdifferenzminimalwert (40) reduziert wurde, und dass die zweite Ausgleichszeitdauer kürzer oder gleich der ersten Ausgleichsdauer ist, wenn in dem Gleichstromüberprüfungsschritt (30) festgestellt wurde, dass innerhalb des ersten oder vorausgehenden Gleichstromausgleichsschritts (29) die Potentialdifferenz (38) zwischen dem Umgebungsreferenzpotential und dem Anlagenreferenzpotential (15) mit dem Ausgleichsstrom unter den vorgegebenen Potentialdifferenzminimalwert (40) gesenkt werden konnte.

6. Verfahren nach einem der vorangehenden Ansprüche, wobei das Anlagenreferenzpotential (15) über einen Wechselspannungsmesskondensator (24) mit einem Umgebungsreferenzpotential verbunden ist, **dadurch gekennzeichnet, dass** in einem Wechselspannungsprüfschritt (35) überprüft wird, ob eine zwischen dem Anlagenreferenzpotential (15) und dem Hochpotential (9) oder zwischen dem Anlagenreferenzpotential (15) und dem Niedrigpotential (10) innerhalb der elektrischen Anlage (2) erfasste Wechselspannungspotentialdifferenz größer als ein vorgebbarer Wechselspannungswarnschwellenwert ist, dass ein Fehlerstromalarmereignis (32) ausgelöst wird, wenn die erfasste Wechselspannungspotentialdifferenz größer als der Wechselspannungswarnschwellenwert ist, und dass anderenfalls in einem nachfolgenden Wechselstromerfassungsschritt (36) während einer Wechselstrommesszeitdauer der Wechselspannungsmesskondensator (24) elektrisch leitend überbrückt wird und eine mit einer Stromstärke korrelierende Wechselstromkenngröße eines Wechselspannungsableitstromflusses erfasst wird, der durch einen Wechselspannungsmesswiderstand (12, 13) und den überbrückten Wechselspannungsmesskondensator (23) zwischen der elektrischen Anlage (2) und dem Umgebungsreferenzpotential fließt, und dass in einem Wechselstromauswerteschritt (37) ausgehend von der mit dem Wechselstromerfassungsschritt (36) erfassten Wechselstromkenngröße ein Fehlerstromalarmereignis (32) ausgelöst wird, wenn die Wechselstromkenngröße größer als ein vorgegebener Wechselstromschwellenwert ist.

7. Verfahren nach Anspruch 6, **dadurch gekennzeichnet, dass** die Wechselstrommesszeitdauer nicht mit der Ausgleichsmessdauer oder gegebenenfalls nicht mit einem Ausgleichszeitintervall (41) überlappt, sodass während der Wechselstrommesszeitdauer das Umgebungsreferenzpotential nicht gleichzeitig über den Gleichstromausgleichwiderstand (21) entweder mit dem gegenüber dem Anlagenreferenzpotential (15) höheren Hochpotential (9) oder dem niedrigeren Niedrigpotential (10) der elektrischen Anlage (2) elektrisch leitend verbunden ist.

8. Verfahren nach einem der vorangehenden Ansprüche, **dadurch gekennzeichnet, dass** nur dann eine Fehlermeldung erzeugt wird, wenn nach Ablauf einer vorgebbaren Prüfdauer in einem zuletzt durchgeführten Gleichstromauswerteschritt (29) oder in einem zuletzt durchgeführten Wechselstromauswerteschritt (37) das Fehlerstromalarmereignis (32) ausgelöst wurde.

9. Verfahren nach einem der vorangehenden Ansprüche, **dadurch gekennzeichnet, dass** in einer Prüfschrittspeichereinrichtung für mehrere aufeinanderfolgende Gleichstromausgleichsschritte (29) und/oder für mehrere aufeinanderfolgende Wechselstromerfassungsschritte (36) jeweils mindestens ein für die jeweilige Durchführung vorgegebener Parameter und mindestens eine während oder nach der Durchführung erfasste Kenngröße abgespeichert wird, die mit der in einem Gleichstromausgleichsschritt (29) erfassten Potentialdifferenz (38) oder mit der in einem Wechselstromerfassungsschritt (36) erfassten Wechselstromkenngröße eines Wechselspannungsableitstromflusses korreliert.

10. Verfahren nach Anspruch 9, **dadurch gekennzeichnet, dass** die in der Prüfschrittspeichereinrichtung gespeicherten Parameterdaten und Kenngrößendaten einer Prüfschrittauswerteeinrichtung zugeführt werden.

11. Verfahren nach einem der vorangehenden Ansprüche, **dadurch gekennzeichnet, dass** das Verfahren dauerhaft in vorgegebenen zeitlichen Abständen zum Nachweisen eines Fehlerstroms einer elektrisch von der Umgebung isoliert zu betreibenden elektrischen Anlage (2) durchgeführt wird.

12. Verfahren nach einem der vorangehenden Ansprüche, **dadurch gekennzeichnet, dass** eine Durchführung des Verfahrens für eine vorgebbare Pausendauer unterbrochen oder nicht erneut eingeleitet wird.

13. Vorrichtung (6) zum Feststellen eines zu hohen Fehlerstroms einer elektrisch von der Umgebung isoliert zu betreibenden elektrischen Anlage (2), wobei die Vorrichtung (6) eine Umgebungsreferenzpotentialkontakteinrichtung (7) aufweist, **dadurch gekennzeichnet, dass** die Vorrichtung (6) eine Betriebsspannungskontakteinrichtung (8) zum Kontaktieren mit einem Hochpotential (9) und einem relativ dazu niedrigeren Niedrigpotential (10) der elektrischen Anlage (2) aufweist, dass die Vorrichtung (6) einen Spannungsteiler (12) aufweist, der zwischen dem Hochpotential (9) und dem Niedrigpotential (10) der elektrischen Anlage (2) ein Anlagenreferenzpotential (15) zwischen dem Hochpotential (9) und dem Niedrigpotential (10) bereitstellt, dass die Vorrichtung (6) eine Vorzeichenermittlungsverbindung (16) zwischen dem Anlagenreferenzpotential (15) und der Umgebungsreferenzpotentialkontakteinrichtung (7) aufweist, in der eine Potentialdifferenzmesseinrichtung (17) angeordnet ist, sodass mit der Potentialdifferenzmesseinrichtung (17) ein Vorzeichen einer Potentialdifferenz (38) zwischen dem Anlagenreferenzpotential (15) und dem Umgebungsreferenzpotential ermittelbar ist, und dass das Hochpotential (9) und das Niedrigpotential (10) jeweils über eine gesonderte Gleichstromausgleichsleitung (18, 19) mit der Umgebungsreferenzpotentialkontakteinrichtung (7) verbunden sind, wobei eine Hochpotentialgleichstromausgleichleitung (18) einen Hochpotentialschalter (20) aufweist, mit welchem das Hochpotential (9) für eine vorgebbare Ausgleichszeitdauer über einen Gleichstromausgleichswiderstand (21) mit der Umgebungsreferenzpotentialkontakteinrichtung (7) verbindbar ist, und wobei eine Niedrigpotentialgleichstromausgleichleitung (19) einen Niedrigpotentialschalter (22) aufweist, mit welchem das Niedrigpotential (10) für eine vorgebbare Ausgleichszeitdauer über einen Gleichstromausgleichswiderstand (21) mit der Umgebungsreferenzpotentialkontakteinrichtung (7) verbindbar ist.

14. Vorrichtung (6) nach Anspruch 13, **dadurch gekennzeichnet, dass** die Vorrichtung (6) eine Kontrolleinrichtung aufweist, mit welcher ein über die Hochpotentialgleichstromausgleichleitung (18) oder über die Niedrigpotentialgleichstromausgleichleitung (19) jeweils bei geschlossenem Hochpotentialschalter (20) bzw. Niedrigpotentialschalter (22) fließender Ausgleichsstrom erfassbar ist, und mit welcher die Ausgleichszeitdauer vorgebbar ist.

15. Vorrichtung (6) nach Anspruch 14, **dadurch gekennzeichnet, dass** die Kontrolleinrichtung derart eingerichtet ist, dass die Kontrolleinrichtung eine Anzahl von Ausgleichszeitintervallen (41) mit einer Ausgleichszeitintervalldauer vorgeben kann, welche in Summe die Ausgleichszeitdauer bilden.

16. Vorrichtung (6) nach Anspruch 14 oder Anspruch 15, **dadurch gekennzeichnet, dass** die Kontrolleinrichtung derart eingerichtet ist, dass die Kontrolleinrichtung in Abhängigkeit von dem jeweils erfassten Ausgleichsstrom eine wechselnde Anzahl von Ausgleichszeitintervallen (41) vorgeben kann.

17. Vorrichtung (6) nach einem der Ansprüche 13 bis 16, **dadurch gekennzeichnet, dass** die Vorrichtung (6) eine Prüfschrittspeichereinrichtung aufweist, in welcher für mehrere aufeinanderfolgende Gleichstromausgleichsschritte (29) und/oder für mehrere aufeinanderfolgende Wechselstromerfassungsschritte (36) jeweils mindestens ein für die jeweilige Durchführung vorgegebener Parameter und mindestens eine während oder nach der Durchführung erfasste Kenngröße abspeicherbar ist.

18. Vorrichtung (6) nach einem der Ansprüche 13 bis 17, **dadurch gekennzeichnet, dass** die Vorrichtung (6) für die Durchführung eines Verfahrens nach einem der Ansprüche 1 bis 12 eingerichtet ist.
